Europäisches Patentamt

European Patent Office

Office européen des brevets

(11) Veröffentlichungsnummer: **0 061 682**
A2

# EUROPÄISCHE PATENTANMELDUNG

(21) Anmeldenummer: 82102322.3

(51) Int. Cl.³: **H 04 N 1/40**

(22) Anmeldetag: 20.03.82

(30) Priorität: 27.03.81 DE 3112094

(43) Veröffentlichungstag der Anmeldung:
06.10.82 Patentblatt 82/40

(84) Benannte Vertragsstaaten:
FR GB IT NL

(71) Anmelder: DR.-ING. RUDOLF HELL GmbH
Grenzstrasse 1-5
D-2300 Kiel 14(DE)

(72) Erfinder: Karius, Helmut
Hannes-Pries-Strasse 21
D-2314 Schönkirchen(DE)

(54) Schaltungsanordnung zum Umwandeln analoger Bildsignale für Schwarz/Weiss-Aufzeichnung.

(57) Schaltungsanordnung zum Umwandeln eines von einem fotoelektrischen Abtaster gelieferten analogen Bildsignals in ein Zweipegelsignal (Schwarz/Weiß-Signal), bei der das vom Abtaster gelieferte Signal an eine Doppelweggleichrichterschaltung angeschaltet wird, der positive und negative Ausgang der Gleichrichterschaltung über zwei in Reihe geschaltete Widerstände miteinander und über je einen Kondensator mit Masse verbunden sind und der Eingang der Doppelweggleichrichterschaltung an den Minuseingang eines Komparators und der Verbindungspunkt der in Reihe geschalteten Widerstände an den Pluseingang des Komparators angeschlossen sind, an dessen Ausgang das Zweipegelsignal erscheint.

Fig. 1

Beschreibung der Erfindung

Schaltungsanordnung zum Umwandeln analoger
Bildsignale für Schwarz/Weiß-Aufzeichnung

Technisches Gebiet

Die vorliegende Erfindung betrifft eine Schaltungsanordnung zum Umwandeln von analogen Bildsignalen
für eine Schwarz/Weiß-Aufzeichnung gemäß dem Oberbegriff des Anspruchs 1.

Zugrundeliegender Stand der Technik

In der Faksimile-Technik besteht bei der Übertragung von Dokumenten die Aufgabe, die von einem
fotoelektrischen Abtaster gelieferten analogen
Bildsignale in ein Zweipegelsignal, das heißt ein
Schwarz/Weiß-Signal, umzuwandeln. Man hat daher
bisher entweder das Bildsignal an festen Schwellen
für Weiß und Schwarz ausgewertet, oder es wurden
sogenannte Pegelautomatiken verwendet, bei denen
ein Weißwertpegel festgelegt wird und an einer
Schwelle die Entscheidung für Schwarz und Weiß
vorgenommen wird. Siehe hierzu so z. B. US-PS
3,159,815. Diese Pegelautomatiken besitzen zwar

- 2 -

eine Nachregelung, wenn sich der Weißwert verändert, aber die Nachregelung ist zu langsam, und graue Farbtöne der Vorlage werden oft falsch interpretiert (DE-AS 11 71 464).

Weiterhin ist in der DE-OS 28 00 759 vorgeschlagen worden, mit einer gleitenden Schwelle zu arbeiten, wobei sogenannte Begleitsignale ausgewertet werden. Solche Schaltungen ermöglichen zwar eine exakte Umwandlung der analogen Bildsignale in zweipegelige Signale, sind aber vom schaltungstechnischen Aufbau her aufwendig und kompliziert.

Offenbarung der Erfindung

Der vorliegenden Erfindung liegt daher die Aufgabe zugrunde, eine einfache und wirksame Schaltung zur Umwandlung eines von einem fotoelektrischen Abtaster gelieferten analogen Bildsignals in ein Zweipegelsignal anzugeben.

Die Erfindung erreicht dies durch die im kennzeichnenden Teil des Anspruchs 1 angegebenen Merkmale.

Kurze Beschreibung der Zeichnungen

Vorteilhafte Weiterbildungen der Erfindung sind in den Unteransprüchen 2 und 3 angegeben.

Die Erfindung wird im folgenden anhand der Figuren 1 - 3 näher erläutert. Es zeigen:

Figur 1 einen schaltungstechnischen Aufbau für die Erfindung,

- 3 -

Figur 2 eine grafische Darstellung der Schwellenspannungen und des Bildsignals und

Figur 3 eine grafische Darstellung des am Ausgang
erscheinenden Zweipegelsignals.

Bester Weg zur Ausführung der Erfindung

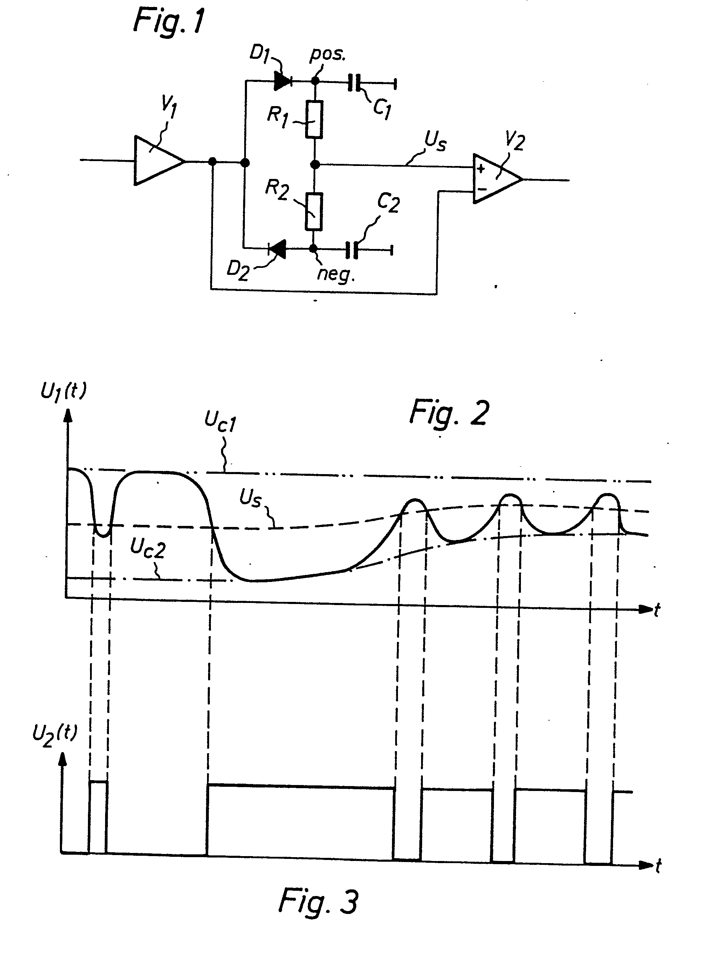

In Figur 1 gelangt das von einem nicht dargestellten fotoelektrischen Abtaster gelieferte
Signal über einen Verstärker $V_1$ an den Eingang
einer Doppelweggleichrichterschaltung $D_1$ und $D_2$.
Der positive und negative Ausgang der Doppelweggleichrichterschaltung sind über eine Reihenschaltung zweier Widerstände $R_1$ und $R_2$ miteinander
verbunden. Weiterhin liegen die Ausgänge der
Doppelweggleichrichterschaltung über Kondensatoren
$C_1$ und $C_2$ an Masse. Der Verbindungspunkt der
in Reihe geschalteten Widerstände $R_1$ und $R_2$
geht an einen Pluseingang eines Vergleichers $V_2$,
und der Minuseingang des Vergleichers $V_2$ ist mit
dem Eingang der Gleichrichterschaltung, das heißt
mit dem vom fotoelektrischen Abtaster gelieferten
Signal, verbunden. Die Kondensatoren $C_1$ und $C_2$
speichern die Spannungen $U_{c1}$ und $U_{c2}$ als
Spitzenwerte entsprechend Weiß und Schwarz. Die
Schwellenspannung $U_s$ liegt zwischen den Spannungen $U_{c1}$ und $U_{c2}$ und wird durch das Widerstandsverhältnis $R_1$ und $R_2$ bestimmt. Sind die
beiden Widerstände $R_1$ und $R_2$ gleich, so liegt
die Schwelle bei 50 % des Signalwertes zwischen
Schwarz und Weiß. Die Widerstände $R_1$ und $R_2$
sind hochohmig, das heißt, sie liegen bei einigen
100 kOhm. Der Kondensator $C_2$, der als Weißwert-

speicher dient, kann kleiner als $C_1$ gewählt werden, damit $U_{c2}$ bei Grauflächen im Bild der Signalspannung folgt, wodurch erreicht wird, daß diese Grauflächen nicht als Schwarz, sondern als Weiß interpretiert werden. Ist in den Grauflächen eine Schrift vorhanden, so wird diese wieder als Schwarz interpretiert.

Der Vorteil dieser Schaltung besteht darin, daß sie eine sichere Schrifterkennung auch bei wechselnder Dichte des Untergrundes und auch der Dichte von Schwarz gewährleistet und daß sie weitgehend unabhängig von absoluten Signalpegeln und vom Signalhub ist. Es ist daher keine Pegelregelung erforderlich.

In Figur 2 ist die Schwellenspannung $U_s$ zusammen mit den Kondensatorspannungen $U_{c1}$ und $U_{c2}$ dargestellt. Das Bildsignal $U_1(t)$ bewegt sich zwischen den Spannungen $U_{c1}$ und $U_{c2}$. Aus den Figuren 2 und 3 erkennt man, daß immer dann, wenn das Bildsignal $U_1(t)$ die Schwellenspannung $U_s$ überschreitet bzw. unterschreitet, am Komparator $V_2$ eine Umklappung vorgenommen wird. Dieses Signal ist in Figur 3 als $U_2(t)$ dargestellt.

Wie leicht zu ersehen ist, handelt es sich um eine einfache und wirkungsvolle Schaltung, die neben der Auswertung des Weißwertes noch den Vorteil hat, daß auch ein schwankender Schwarzwert ausgewertet wird, was bei anderen ähnlichen Schaltungen nicht der Fall ist.

- 5 -

Gewerbliche Verwertbarkeit

Bürofernkopierer, Telebildgeräte, Wetterkartenübertragung, Faksimiletechnik.

Gegenstand der Erfindung

Patentansprüche

1. Schaltungsanordnung zum Umwandeln eines von einem fotoelektrischen Abtaster gelieferten analogen Bildsignals in ein Zweipegelsignal (Schwarz/Weiß-Signal), dadurch gekennzeichnet, daß das vom Abtaster gelieferte Signal an eine Doppelweggleichrichterschaltung anschaltbar ist, daß der positive und negative Ausgang der Gleichrichterschaltung über zwei in Reihe geschaltete Widerstände miteinander und über je einen Kondensator mit Masse verbunden sind und daß der Eingang der Doppelweggleichrichterschaltung an den Minuseingang eines Komparators und der Verbindungspunkt der in Reihe geschalteten Widerstände an den Pluseingang des Komparators angeschlossen sind, an dessen Ausgang das Zweipegelsignal erscheint.

2. Schaltungsanordnung nach Anspruch 1, dadurch gekennzeichnet, daß die in Reihe geschalteten Widerstände hochohmig sind und etwa gleichen Widerstandswert haben.

3. Schaltungsanordnung nach Anspruch 1 oder 2,

- 2 -

dadurch gekennzeichnet, daß der an den negativen
Ausgang der Gleichrichterschaltung angeschlossene
Kondensator kleiner ist als der am positiven Ausgang angeschlossene Kondensator.

Fig. 1

Fig. 2

Fig. 3